# EUROPEAN PATENT APPLICATION

(11) **EP 3 007 217 A1**
(43) Date of publication of application: **13.04.2016**
(21) Application number: 14188510.3
(22) Date of filing: 10.10.2014
(51) Int. Cl.: H01L 21/673, G01R 31/28

(54) **Chip tray**

(71) Applicant: Rasco GmbH, 83059 Kolbermoor (DE)
(72) Inventor: Wammetsberger, Christian, 83059 Kolbermoor (DE); Laußer, Ulrich, 83131 Nußdorf am Inn (DE)
(74) Representative: Heinze, Ekkehard

(57) **Abstract**

A chip tray, comprising: a first plate configured to allow a plurality of semiconductor elements to be placed thereon, a positioning and clamping mechanism for pressing and holding the semiconductor elements in predetermined locations on the first plate, and actuator means for actuating the positioning and clamping mechanism comprising movable parts of the positioning and clamping mechanism which can be actuated simultaneously to perform a pressing and holding operation and a releasing operation by the positioning and clamping mechanism simultaneously for all the semiconductor elements, wherein the positioning and clamping mechanism comprises a second plate which is laterally shiftable and lockable with respect to the first plate and comprises a plurality of openings and of elastic members each corresponding to an opening and each provided with a pressure piece adapted for abutting against at least one edge of one of the semiconductor elements, characterized in that wherein the elastic members are self-guiding elements mounted on a surface of the second plate, and elastically deformable in a plane parallel to the plane of the second plate in a self-guiding manner.

## Description

The invention is related to a chip tray comprising a first plate configured to allow a plurality of semiconductor elements to be placed thereon, a positioning and clamping mechanism for pressing and holding the semiconductor elements in predetermined locations on the first plate, the mechanism comprising movable parts to be actuated simultaneously to perform a pressing and holding operation and a releasing operation by the positioning and clamping mechanism simultaneously for all the semiconductor elements, wherein the positioning and clamping mechanism comprises a second plate which is laterally shiftable and lockable with respect to the first plate and comprises a plurality of openings and of elastic members each corresponding to an opening and each provided with a pressure piece adapted for abutting against one of the semiconductor elements.

In general, in the process of manufacturing semiconductor devices, a number of semiconductor chips is formed on a semiconductor wafer using precision photolithographic technology and other technologies, and thereafter the semiconductor chips are cut apart by a dicing process. Each of these semiconductor chips is contained (packaged) in a mold with a predetermined shape to form each individual semiconductor device.

In such a semiconductor manufacturing process, conventionally, tests of the electrical characteristics in the semiconductor wafer state are carried out using a probe device, and tests of the electrical characteristics of the packaged semiconductor device are carried out using a handler.

Besides such wafer-based tests, for many types and applications of integrated circuits or other semiconductor elements, respectively, device-based test procedures are required and have been established. Corresponding test apparatus' have been developed, and likewise handler apparatus' have been developed, which are adapted to handle the separated semiconductor devices in such tests and other post-processing procedures, such as sorting out elements which do not fulfil the test requirements are classifying the elements in accordance with the respective test results. In connection with such handlers, specifically adapted chip trays or carriers are being used.

A chip tray according to the preamble of claim 1 is disclosed in JP 03073551 A.

It is an object of the invention, to improve such chip tray, specifically with regard to a simple and cost-efficient construction, reliable function and easy handling thereof.

This object is solved by a chip tray according to claim 1. Embodiments of the invention are subject of the dependent claims.

Accordingly, it is an aspect of the invention, to form the elastic members, which are associated to each of the openings of the second plate for providing an elastic force to align and hold the respective semiconductor element in place, as self-guiding elements which are mounted on one of the two surfaces of the second plate and deformable/movable in a plane parallel to the plane of extension of the second plate.

In an embodiment of the invention pressure pieces, which are adapted for abutting against the respective semiconductor elements, are formed as separate parts, each preferably resting on an end portion of the respective elastic member.

In an embodiment of the invention, the chip tray comprises a third plate covering the second plate and provided with a plurality of openings arranged correspondingly to the openings of the second plate and determined to allow access to the semiconductor elements from above the chip tray. This access enables implementing all required test procedures, as far as these rely on an access to portions of the semiconductor element from above, but at the same time provides for the required protection of the elements.

According to a further embodiment of the invention, the first plate comprises a plurality of stop portions, each arranged to receive one of the plurality of semiconductor elements and to position and clamp it in the tray, together with a respective pressure piece of the second plate. Specifically, these stop portions are formed integral with and protrude from the upper surface of the first plate. In this embodiment, the stop portions for correctly aligning the semiconductor elements can be formed in a technologically simple and cost-efficient way.

In a further embodiment, below each of the elastic members a recess is provided in the upper surface of the first plate, to provide for a free deformational motion of the elastic members mounted on the lower surface of the second plate. In an alternative embodiment, above each of the elastic members a free space is provided with respect to the third plate, to provide for a free deformational motion of the elastic members mounted on the upper surface of the second plate. In both embodiments, the self-aligning properties of the elastic members mounted on the second plate remain undisturbed by any contact with an adjacent surface of the first or third plate, respectively. In so far, these embodiments serve for increasing the reliability and durability of the chip tray.

In a further embodiment of the invention, the openings in the second plate are arranged such that the stop portions on the first plate protrude through the openings and assist in aligning the second plate with respect to the first plate. This facilitates an easy and accurate assembling of the chip tray.

The above-mentioned stop portions on the first plate can, more specifically, be adapted to accommodate leads ("legs") protruding from the housing of specific semiconductor elements and appropriately holding and protecting them.

In a further embodiment, the elastic members comprise approximately S-like or Ω-like steel springs extending parallel to the plane of the first and second plate. In a further embodiment, independent of the specific overall shape of the steel springs, the elastic members are formed to have a rectangular cross section, e.g. cut-out or etched from a spring steel plate, or are made by bending a spring steel wire.

These other embodiments and many other possible shapes of steel springs serving as elastic members form a reliable, durable and cost-efficient implementations of a crucial component of the inventive chip tray. However, even elastic members formed as resilient plastic parts or made from other metals than steel can well fulfil the purpose of the elastic members and can, in light of specific requirements to the chip tray, be preferable implementations.

In a further embodiment of the invention, the pressure pieces are plastic parts. This avoids any damage to the sensible edges of the semiconductor elements, which might occur with configurations where metal parts directly abut against the semiconductor elements, and such plastic parts are highly cost-efficient. Alternatively, the pressure pieces can be embodied as metal parts or even as appropriately shaped portions of the elastic members themselves.

In a further embodiment, the pressure pieces are essentially Y-shaped or L-shaped. These are embodiments which can be manufactured and assembled in a simple way, and are, at the same time, highly efficient in transferring a "diagonal" elastic force from the respective elastic member to two edges of a semiconductor element which abut against each other under a right angle (90°). However, in accordance to specific conditions or requirements, respectively, differently shaped pressure pieces can well be used or even be preferred. In an embodiment specifically adapted to the above-mentioned semiconductor elements with leads protruding from their housing, the pressure pieces or portions, respectively, can simply be straight, to contact just one edge of the semiconductor elements and to excert a pressure force on it, which is directed normally to that edge.

In a more specific implementation, the pressure pieces have toothed or otherwise recessed contact edges for contacting edges of the respective semiconductor element to be clamped therewith. In such embodiments, the lateral fraction between the respective edges of the semiconductor element and the abutting edges of the pressure piece can be increased and some free space be provided for accommodating small irregularities, such a s dust particles or protrusions or contact legs protruding from the semiconductor element housing. Thereby, it can be avoided that such particles or protrusions or similar can adversely influence the correct positioning of the respective semiconductor elements in the chip tray.

In a further embodiment, the chip tray comprises at least one first actuator element for opening and closing the chip tray and at least one second actuator element for locking and unlocking the chip tray. This embodiment provides for an easy and convenient automated actuating and overall handling of the chip tray. For this purpose, the actuator elements provided on the chip tray are adapted to cooperate with electric, hydraulic, or pneumatic actuator devices of a carrier loading station or post-processing station, respectively. More specifically, if the chip tray is formed as an elongated rectangle, comprising two long edges and two short edges, two first actuator means are arranged close to a first long edge and two second actuator means are arranged close to the opposed second long edge of the rectangle.

At least in certain embodiments thereof, the present invention provides a chip tray or carrier, respectively, which
- can be manufactured with high accuracy in highly automated and efficient processes,
- is highly reliable and maintains its reliable function over a long lifetime,
- provides for a universal testing and post-processing of the semiconductor elements, at the same time avoiding any damage to these elements, and
- can easily be handled and embedded into well-established test procedures and handler constructions.

Further embodiments and advantages of the invention become more apparent in light of the following description, wherein
Fig. 1 is a top view of a chip tray according to a first embodiment of the invention, shown together with surrounding portions of a carrier loading station;
Fig. 2 is a top view of the chip tray of Fig. 1;
Fig. 3 is an explosion view of the chip tray of Fig. 1;
Fig. 4 is an overall view of the chip tray of Fig. 1, with the third plate (top plate) removed;
Fig. 5 is a detail view of the chip tray of Fig. 1;
Fig. 6 is another detail view of the same portion of the chip tray, with the top plate removed;
Fig. 7 is a cross-sectional detail view of a semiconductor element clamping portion of the chip tray of Fig. 1;
Fig. 8 is a detail view of a chip tray according to a second embodiment of the invention; and
Fig. 9 is a cross-sectional detail view of a semiconductor element clamping portion of the chip tray of Fig. 8.

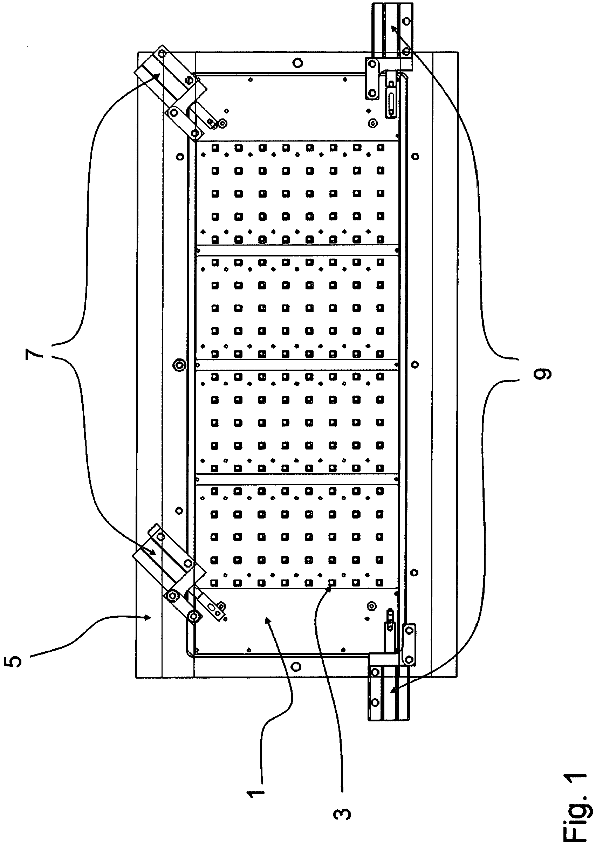

Fig. 1 shows a chip tray (carrier) 1 accommodating a plurality of semiconductor elements 3, inserted in a carrier loading station 5 comprising two first actuator devices 7 for opening and closing the chip tray and two second actuator devices 9 for locking and unlocking the chip tray.

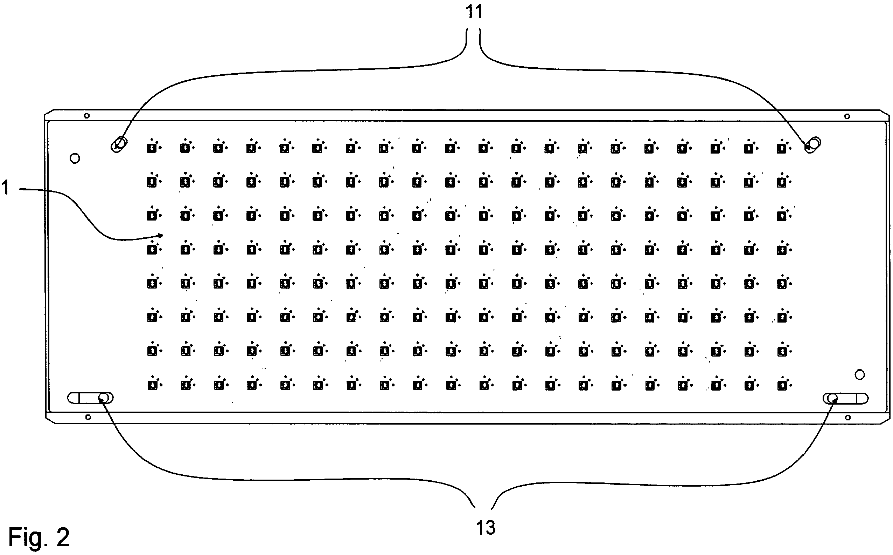

Fig. 2 shows the chip tray 1 once again, wherein first actuator elements 11 of the chip tray, which are provided for opening and closing the chip tray manually or by means of the first actuator devices 7 shown in Fig. 1, as well as second actuator elements 13, for locking and unlocking the chip tray manually or by means of the second actuator devices 9 shown in Fig. 1, can be seen. The chip tray has the overall shape of an elongated rectangle, wherein the first actuator elements 11 both sit close to a first long edge of the rectangle, whereas the second actuator elements 13 both are arranged close to the second long edge.

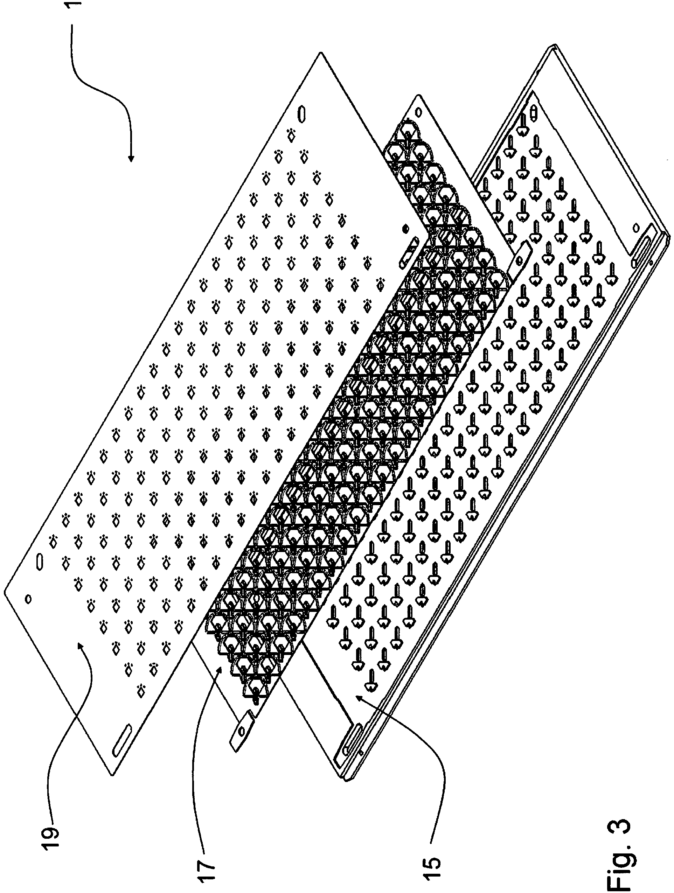

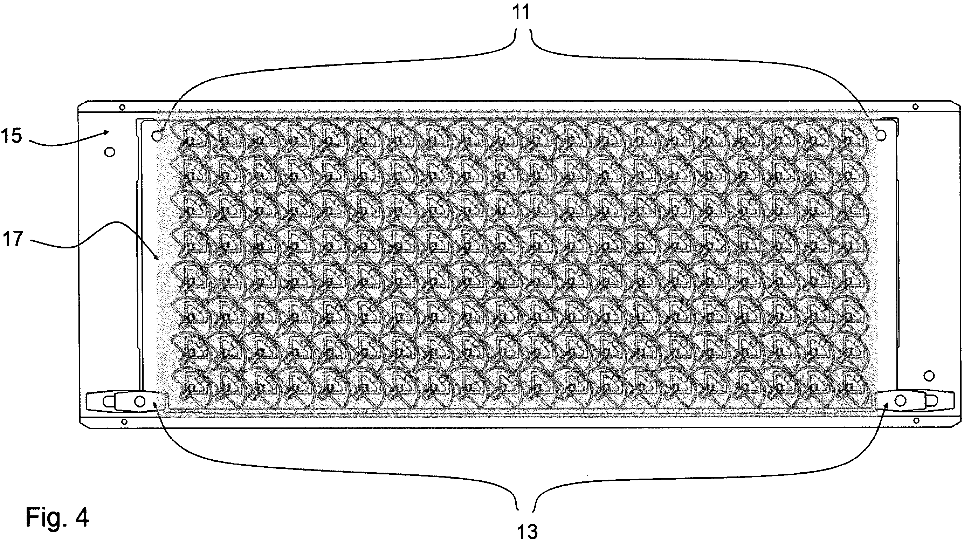

Fig. 3 is an explosion view of the chip tray 1, showing that it has basically a three-layer structure, comprising a first plate (bottom layer) 15, a second plate (spring layer) 17 arranged on the first plate, and a third plate (top layer) 19 arranged above the second plate and fully covering the first plate. Fig. 4 shows the second plate (spring layer) 17, arranged on the first plate (bottom layer) 15 but with the top layer removed. It can be recognized that on the second plate a positioning and clamping mechanism is arranged which comprises a plurality of positioning and clamping members (not specifically designated here), each associated to an opening in the second plate and to a semiconductor element accommodated therein.

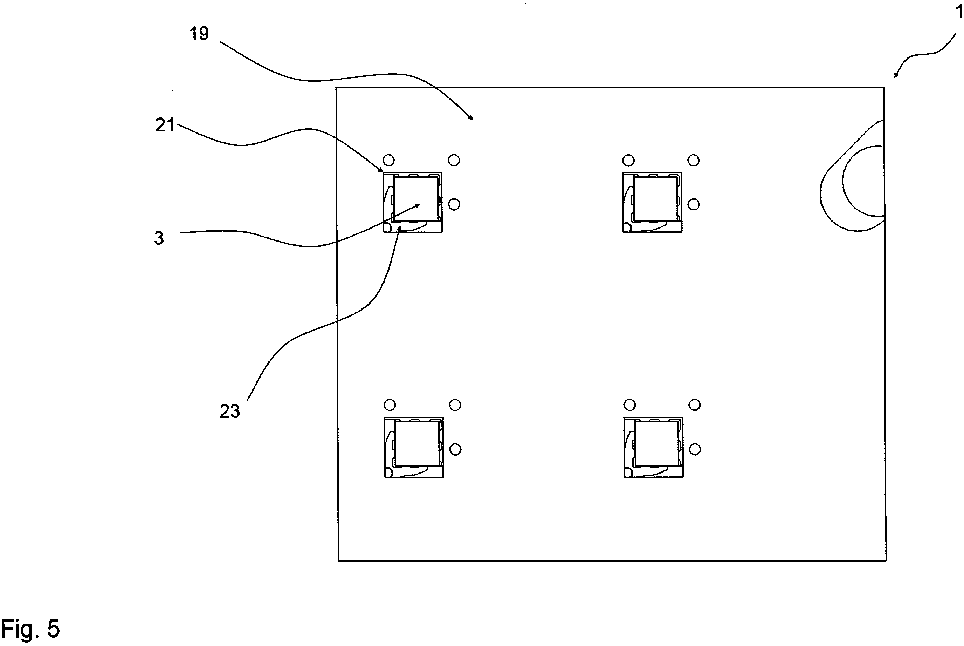

Fig. 5 shows a portion of the chip tray 1 in detail, i.e. four openings 21 in the third layer 19, each providing access to a single semiconductor element 3 accommodated in the chip tray. Besides the respective semiconductor element, in each of the openings 21 (partially) an element of the positioning and clamping mechanism can be recognized, namely a pressure piece 23 which contacts two edges of the semiconductor element which are perpendicular to each other.

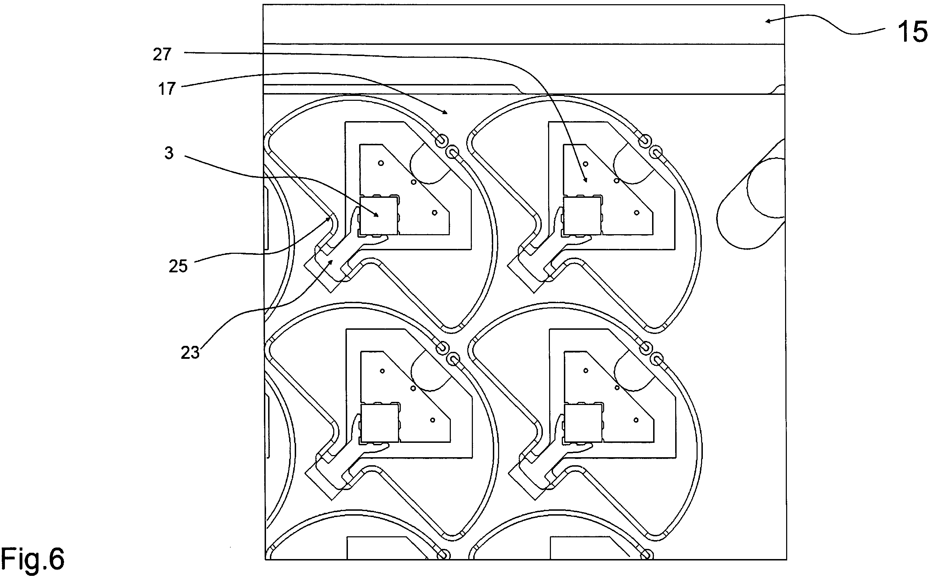

In Fig. 6, wherein the same portion is shown again, but with the third plate (top layer) illustrated in a "transparent" manner, the pressure pieces 23 in their full extension and overall shape can be seen, as well as corresponding steel springs 25 which serve as elastic members exerting a clamping force on the respective semiconductor elements, transferred to the semiconductor elements by means of the pressure pieces 23. The steel springs (elastic members) 25 each are basically Ω-shaped and have two closely neighbored free ends which protrude into fixation bars of the second plate (spring layer) 17 and hold the spring in its position on the spring layer and relative to the semiconductor element clamping position. The respective pressure piece is mounted on a protruding opposite portion of the spring 25. Furthermore, it can be recognized that each of the semiconductor elements rests against a stop bar 27 provided on the first plate (bottom layer) 15.

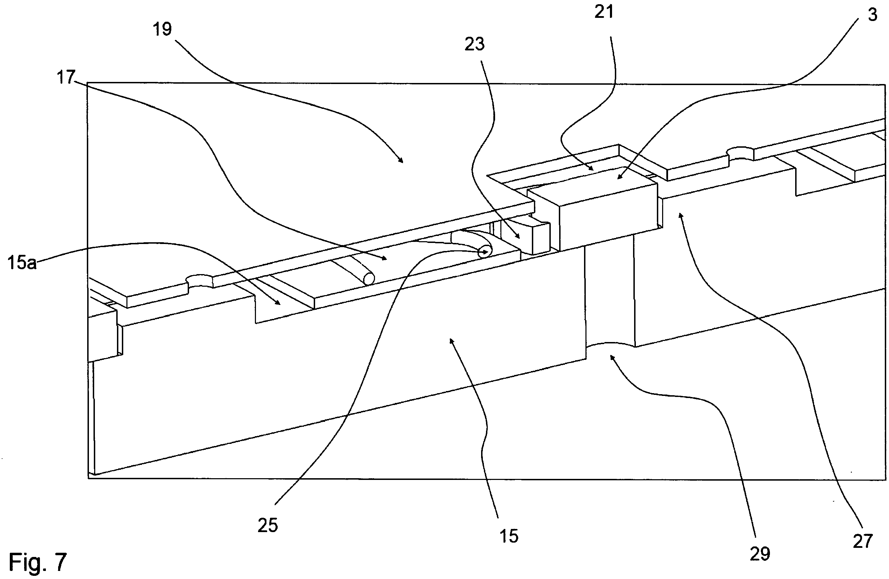

Fig. 7 shows one of the semiconductor element clamping positions in more detail, in a cross-sectional view. It can be recognized that the bottom layer 15 has a recess 15a which accommodates both the semiconductor element 3 and the associated elements of the positioning and clamping mechanism, i.e. a portion of the spring layer 17 together with the steel spring 25 mounted thereon and the pressure piece 23 connected to the steel spring 25. One of the edge portions of this recess, with regard to the pressure piece 23 on the opposite side of the semiconductor element 3, forms the respective stop bar 27.

An opening 29 in the first plate 15, in the position of the semiconductor element 3, provides for an access to the semiconductor element from below, whereas the opening 21 in the top layer 19 provides for the required access from above, for testing or other post-processing purposes. Above the spring elements 25 arranged on the upper surface of the spring layer 17, a free space is provided with respect to the lower surface of the top layer, to avoid any slide contact and friction between the self-guiding steel springs and the top layer.

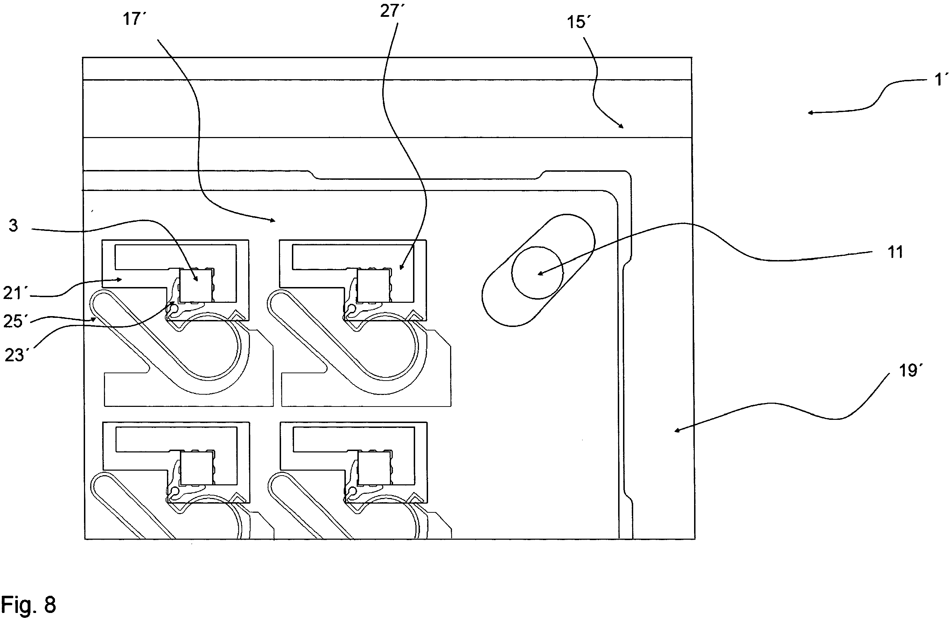

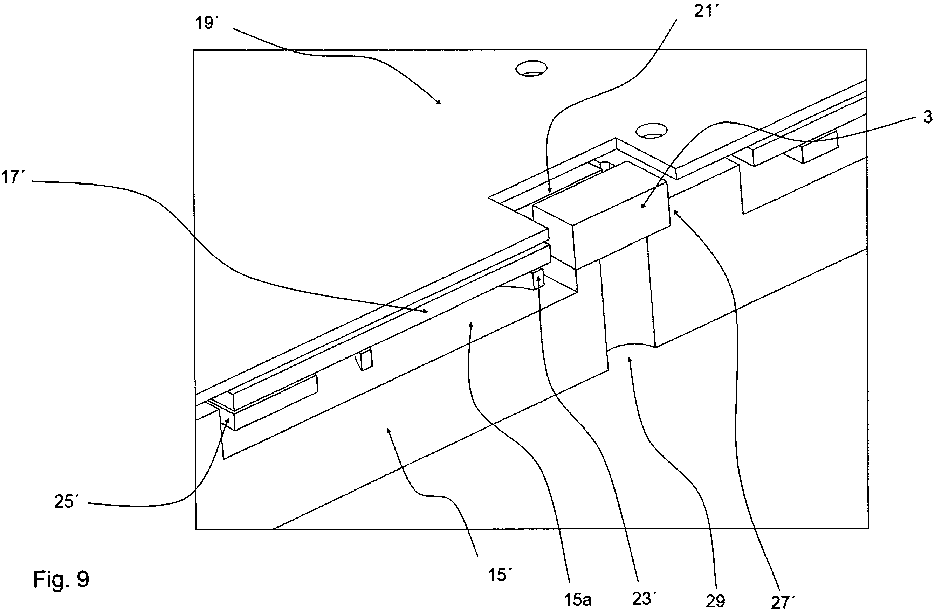

Figs. 8 and 9 illustrate aspects of a chip tray 1' according to a second embodiment of the invention, which distinguish the second embodiment from the first embodiment as shown in Figs. 1 to 7 and explained above. In all those features which are not explained below, the chip tray according to the second embodiment is basically identical to the first embodiment, and these features are not explained again. Reference numerals in Figs. 8 and 9 have been designated such that identical parts as those of the first embodiments have identical reference numerals, whereas similar (non-identical) parts have numerals which are similar to those of the first embodiment.

Firstly, it is to be mentioned that the chip tray 1' has a very similar shape and overall layer configuration as the chip tray 1 of Figs. 1 to 7. However, all of the first, second and third plates 15', 17', and 19' are slightly different from the first embodiment. As can be seen in Fig. 8, the first plate (bottom layer) 15' has stop bars 27' of a slightly different shape formed thereon. Furthermore, as shown in Fig. 9, the stop bars 27' are higher than in the first embodiment and extend immediately beneath the lower surface of the third plate (top layer) 19'.

Likewise, the second plate (spring layer) 17' is arranged immediately beneath the top layer (with just a minimum distance there between), and elastic members (steel springs cut-out from a steel spring sheet) 25' are mounted to the lower surface of the second plate 17'. Below the steel springs 25', a recess 15a is provided in the first plate 15', to avoid any contact between the first plate and the lower surface of the steel springs 25' which are, as in the first embodiment, self-guiding in their lateral movements when positioning and clamping or releasing, respectively, the semiconductor elements 3.

As can be seen in Fig. 8, the shape of the steel springs is clearly different from the first embodiment, and they have separately formed pressure pieces 23' arranged at their respective free ends. In this embodiment, the pressure pieces 23' are L-shaped and, as in the first embodiment, made from wear-resistant plastic, e.g. as mold-formed pieces. Again, the contact edges of the pressure pieces 23' which are determined to abut against the semiconductor elements, are not straight but slightly toothed or waved. The shape of the holes 21', formed in the third plate 19' for allowing access to the semiconductor elements 3 from above, is different from the first embodiment. Similar as the stop bars 27' formed on the first plate 15', they are L-shaped, and both the stop bars 27' and the pressure pieces 23' can be seen from above.

The embodiments and aspects of the invention explained above are not determined to limit the scope of the invention, which is exclusively to be determined by the attached claims. Many modifications of the inventive concept are possible within the scope of the claims and, more specifically, arbitrary combinations of the several claim features are considered to be within the scope of the invention.

## Claims

1. A chip tray, comprising: a first plate configured to allow a plurality of semiconductor elements to be placed thereon, a positioning and clamping mechanism for pressing and holding the semiconductor elements in predetermined locations on the first plate, the positioning and clamping mechanism comprising movable parts which can be actuated simultaneously to perform a pressing and holding operation and a releasing operation by the positioning and clamping mechanism simultaneously for all the semiconductor elements,
wherein the positioning and clamping mechanism comprises a second plate which is laterally shiftable and lockable with respect to the first plate and comprises a plurality of openings and of elastic members each corresponding to an opening and each provided with a pressure piece adapted for abutting against at least one edge of one of the semiconductor elements,
wherein the elastic members are mounted on a surface of the second plate and elastically deformable in a plane parallel to the plane of the second plate in a self-guiding manner.

2. The chip tray of claim 1, comprising a third plate covering the second plate and provided with a plurality of openings arranged correspondingly to the openings of the second plate and determined to allow access to the semiconductor elements from above the chip tray.

3. The chip tray of claim 1 or 2, wherein the first plate comprises a plurality of stop portions, each arranged to receive one of the plurality of semiconductor elements and to position and clamp it in the tray, together with a respective pressure piece of the second plate, the stop portions being formed integral with and protruding from the upper surface of the first plate.

4. The chip tray of one of the preceding claims, wherein below each of the elastic members a recess is provided in the upper surface of the first plate, to provide for a free deformational motion of the elastic members mounted on the lower surface of the second plate.

5. The chip tray of claim 2 or 3, wherein above each of the elastic members a free space is provided with respect to the third plate, to provide for a free deformational motion of the elastic members mounted on the upper surface of the second plate.

6. The chip tray of one of claims 3-5, wherein the openings in the second plate are arranged such that the stop portions on the first plate protrude through the openings and assist in aligning the second plate with respect to the first plate.

7. The chip tray of one of claims 3-6, wherein the stop portions are adapted as lead supports for leads protruding from the semiconductor elements.

8. The chip tray of one of the preceding claims, wherein the elastic members comprise S-like or Ω-like steel springs extending parallel to the plane of the first and second plate.

9. The chip tray of one of the preceding claims, wherein the elastic members are curved spring steel parts of rectangular cross-sectional shape or bent spring steel wires.

10. The chip tray of one of the preceding claims, wherein the pressure pieces are formed as separate parts, each resting on an end portion of the respective elastic member.

11. The chip tray of claim 10, wherein the pressure pieces are plastic parts.

12. The chip tray of one of the preceding claims, wherein the pressure pieces are essentially Y-shaped or L-shaped.

13. The chip tray of one of the preceding claims, wherein the pressure pieces have toothed or otherwise recessed contact edges for contacting edges of the respective semiconductor element to be clamped therewith.

14. The chip tray of one of the preceding claims, comprising at least one first actuator element for opening and closing the chip tray and at least one second actuator element for locking and unlocking the chip tray.
